# DEMANDE DE BREVET EUROPEEN

(11) **EP 2 650 911 A1**
(43) Date de publication de la demande: **16.10.2013**
(21) Numéro de dépôt: 13162988.3
(22) Date de dépôt: 09.04.2013
(51) Int. Cl.: H01L 21/285

(54) **Reprise de contact sur substrat semi-conducteur heterogene**

(30) Priorité: 12.04.2012 FR 1253363
(71) Demandeur: Commissariat à l'Énergie Atomique et aux Énergies Alternatives, 75015 Paris (FR); STMicroelectronics (Crolles 2) SAS, 38920 Crolles (FR)
(72) Inventeur: Morand, Yves, 38000 GRENOBLE (FR); Baudot, Charles, 38660 LUMBIN (FR); Nemouchi, Fabrice, 38430 MOIRANS (FR)
(74) Mandataire: Ilgart, Jean-Christophe

(57) **Abrégé**

La présente demande concerne un procédé de réalisation d'un dispositif microélectronique comportant une pluralité de zones à base d'un composé de matériau métallique et de matériau semi-conducteur, à partir de zones semi-conductrices (104, 108) à base de matériaux semi-conducteurs différents et sur lesquelles une fine couche semi-conductrice (112) est formée préalablement au dépôt d'une couche métallique afin d'abaisser la barrière de nucléation des zones semi-conductrices réagissant avec la couche métallique (116).

## Description

### DOMAINE TECHNIQUE

La présente invention concerne le domaine des dispositifs à base de semi-conducteur et vise en particulier un procédé de réalisation d'un dispositif à semi-conducteur intégrant des régions à base de matériaux semi-conducteurs différents et qui sont recouvertes et en contact avec des zones à base d'alliages ou de composés différents de semi-conducteur et de métal ou ayant des compositions respectives différentes.

Elle permet une réalisation à basse température de composés à base de semi-conducteur et de métal à partir de matériaux semi-conducteurs différents.

La présente invention s'applique notamment à la réalisation de zones de prises de contacts pour des dispositifs microélectroniques intégrant des zones semi-conductrices formées de matériaux semi-conducteurs différents.

### ART ANTÉRIEUR

On cherche parfois, pour certaines applications, à réaliser des dispositifs microélectroniques intégrant des matériaux semi-conducteurs différents.

Dans de tels dispositifs, pour réaliser des prises de contact électrique sur des zones semi-conductrices, il est bien connu de former sur ces zones semi-conductrices des régions composées d'un alliage de métal et de semi-conducteur. La formation dudit alliage de métal et de semi-conducteur est classiquement réalisée par dépôt d'un métal sur les zones semi-conductrices puis en effectuant un traitement thermique selon une durée et une température données.

Dans le cadre, par exemple, d'applications photoniques, on peut chercher à vouloir co-intégrer des matériaux semi-conducteurs différents sur un même support, par exemple une ou plusieurs zones à base de germanium utiles à une détection des photons, ainsi qu'une ou plusieurs zones à base de silicium.

Or, les conditions de réalisation de composés métal-semi-conducteur à partir de matériaux semi-conducteurs différents, varient de manière significative d'un matériau semi-conducteur à l'autre.

Les conditions de température de formation et de stabilité thermique peuvent en particulier différer d'un composé à l'autre.

Une formation simultanée de régions à base d'un composé métal-semi-conducteur à partir de zones de matériaux semi-conducteurs différents est donc difficile à mettre en oeuvre.

Lorsqu'on souhaite par exemple réaliser des régions de contact sur un dispositif doté à la fois de zones de silicium et de germanium, il est connu d'utiliser du Ni pour former des régions d'alliage de métal-semi-conducteur présentant une faible résistance de contact.

La formation de composés à base de nickel et de semi-conducteur est bien différente d'un matériau semi-conducteur à l'autre.

En outre, il existe un intervalle de températures de traitement thermique optimal pour permettre d'obtenir des composés à base de semi-conducteur et de Ni ayant une faible résistivité. Cet intervalle n'est pas le même entre le Silicium et le Germanium.

La fenêtre dans laquelle les intervalles de température optimaux se recouvrent pour former du NiSi et du NiGe est restreinte et située à des températures élevées généralement comprises entre 350°C et 430°C.

Il se pose donc le problème de réaliser à partir de zones de matériaux semi-conducteurs différents, des zones d'alliage métal-semi-conducteur ayant une faible résistivité tout en utilisant un budget thermique limité.

### EXPOSÉ DE L'INVENTION

La présente invention concerne un procédé de réalisation d'un dispositif à semi-conducteur comportant une pluralité de zones à base d'un composé de matériau métallique et de matériau semi-conducteur, comprenant des étapes consistant à :
- former sur un support comportant au moins une première zone semi-conductrice à base d'un premier matériau semi-conducteur et au moins une deuxième zone semi-conductrice à base d'un deuxième matériau semi-conducteur différent du premier matériau semi-conducteur, une fine couche semi-conductrice en contact avec le premier matériau semi-conducteur et le deuxième matériau semi-conducteur,
- déposer une couche métallique sur la fine couche semi-conductrice,
- effectuer un traitement thermique ou recuit selon une durée donnée et une température donnée de manière à former au moins une première région à base d'un premier composé de matériau métallique et de matériau semi-conducteur sur ladite première zone semi-conductrice et au moins un deuxième région à base d'un composé de matériau métallique et de matériau semi-conducteur sur ladite deuxième zone semi-conductrice.

La formation d'un composé de métal et de semi-conducteur par réaction à l'état solide passe notamment par une phase de germination également communément appelée « nucléation » (anglicisme de nucleation).

La fine couche semi-conductrice est prévue avec une épaisseur et un matériau semi-conducteur, prévus de sorte qu'elle présente une barrière d'énergie de germination ou barrière à la nucléation inférieure à celle d'au moins ladite première zone semi-conductrice.

En facilitant la phase de germination ou nucléation, on peut ainsi faciliter la formation des zones d'alliages ou de composés de semi-conducteur et de métal ayant des compositions différentes, tout en réduisant le budget thermique nécessaire à la formation de ces alliages ou composés.

La fine couche semi-conductrice est de préférence continue. La fine couche semi-conductrice a de préférence une épaisseur supérieure à la taille des germes critique des composés en formation ou destinés à être formés.

Selon une possibilité de mise en oeuvre, du procédé, le premier matériau semi-conducteur peut être du Si.

Dans ce cas, la fine couche semi-conductrice est prévue à base d'un matériau semi-conducteur présentant à volume et surfaces égales de matériau, une barrière d'énergie à la germination ou à la nucléation inférieure à celle de ladite première zone semi-conductrice.

La fine couche semi-conductrice peut être en particulier à base de Ge ou de SiGe.

Selon une possibilité de mise en oeuvre, le deuxième matériau semi-conducteur peut être du Ge ou du SiGe.

Le procédé peut comprendre en outre, après ladite étape de recuit, une étape de retrait de la portion restante de la couche métallique n'ayant pas réagi.

La durée donnée dudit recuit, la température donnée dudit recuit, et l'épaisseur de la couche métallique, peuvent être prévus de sorte que le matériau semi-conducteur donné de ladite fine couche semi-conductrice est totalement consommé.

Lorsque le matériau semi-conducteur de ladite fine couche semi-conductrice et le matériau semi-conducteur de la première zone semi-conductrice sont différents, on évite ainsi de conserver une interface formée entre le matériau semi-conducteur de ladite fine couche semi-conductrice et le matériau semi-conducteur de la première zone semi-conductrice, qui peut être néfaste en termes de résistance d'accès à la première zone semi-conductrice.

Après ledit retrait d'une portion restante de ladite couche métallique, le procédé peut comprendre en outre une ou plusieurs étapes de recuit supplémentaire(s).

Selon une possibilité de mise en oeuvre du procédé, ladite couche métallique peut être à base de Ni.

Selon une possibilité de mise en oeuvre du procédé, le recuit peut être réalisé sous atmosphère oxydante. Cela peut permettre d'éviter la formation intempestive de cavités ou de trous entre les zones semi-conductrices et les régions à base de composé de semi-conducteur et de métal.

La présente invention concerne également un dispositif à semi-conducteur obtenu à l'aide d'un procédé tel que défini précédemment et comportant une pluralité de zones à base d'un composé de matériau métallique et de matériau semi-conducteur, le dispositif comprenant au moins une première région à base d'un premier composé à base de métal et de semi-conducteur reposant sur une première zone semi-conductrice et au moins un deuxième région à base d'un composé de métal et de semi-conducteur reposant sur une deuxième zone semi-conductrice, le deuxième composé étant différent du premier composé.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- les figures 1A-1E illustrent un exemple de procédé suivant l'invention, de réalisation de zones d'alliage de métal et de semi-conducteur de compositions différentes à partir de zones de matériaux semi-conducteurs différents disposées sur un même support ;
- les figures 2A-2E illustrent un autre exemple de procédé suivant l'invention, de réalisation de zones d'alliage métal-semi-conducteur sur des composants d'un dispositif microélectronique à partir de zones de matériaux semi-conducteurs différents ;
- les figures 3A-3B illustrent une variante d'un exemple de procédé suivant l'invention ;
- la figure 4 donne des exemples de courbes d'évolution d'énergie libre de germes respectivement à base de Silicium et à base de Germanium, en fonction du rayon des germes.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

Un exemple de procédé de réalisation d'un dispositif à semi-conducteur, en particulier d'un dispositif microélectronique doté sur un même support d'au moins une première zone à base d'un alliage ou d'un composé à base d'un premier matériau semi-conducteur et d'un matériau métallique donné et d'au moins une deuxième zone à base d'un alliage, ou d'un composé, à base d'un deuxième matériau semi-conducteur et ledit matériau métallique, va à présent être donné.

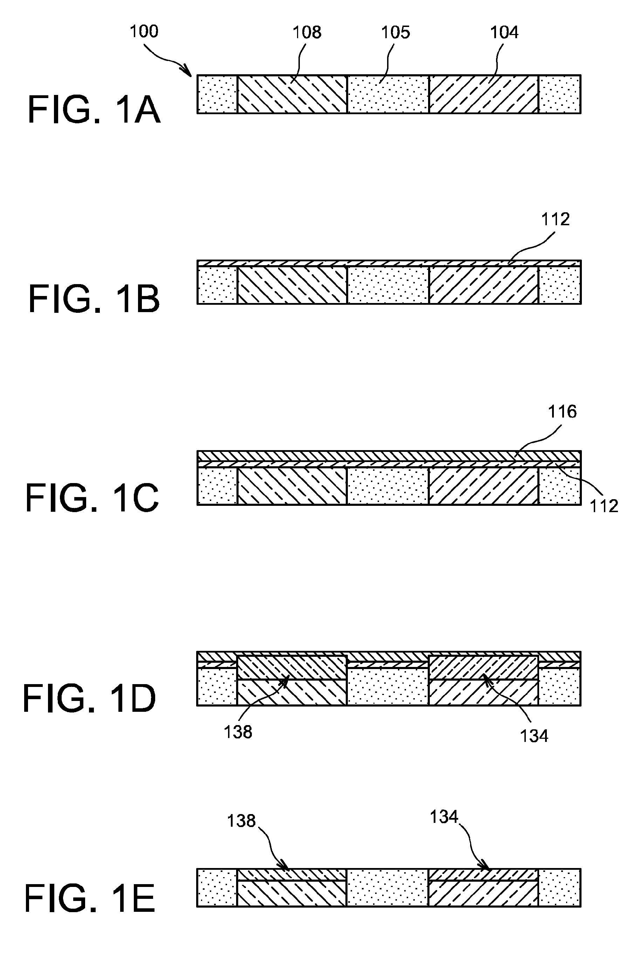

Le matériau de départ du procédé peut être un support 100 comprenant une première zone 104 qui est à base d'un premier matériau semi-conducteur, par exemple du silicium, ainsi qu'une deuxième zone 108 à base d'un deuxième matériau semi-conducteur par exemple du germanium. Les zones semi-conductrices 104 et 108 peuvent être séparées l'une de l'autre par une zone isolante à base d'au moins un matériau diélectrique tel que par exemple du SiO₂ (figure 1A).

Ensuite, on forme, par exemple par dépôt, une fine couche semi-conductrice 112 recouvrant, et en contact avec, la zone première semi-conductrice 104 et la zone deuxième semi-conductrice 108 (figure 1B).

La fine couche semi-conductrice 112 est à base d'un matériau semi-conducteur donné, par exemple du Germanium, et prévue avec une épaisseur donnée inférieure à celle des zones semi-conductrices 104 et 108.

La fine couche semi-conductrice 112 peut avoir une épaisseur donnée comprise par exemple entre 1 nm et 30 nm, de préférence entre 5 nm et 20 nm.

La formation de la fine couche semi-conductrice 112 peut être précédée par un nettoyage du support, en particulier des zones semi-conductrices 104, 108, afin de retirer d'éventuels contaminants ainsi qu'une éventuelle fine couche d'oxyde semi-conducteur qui pourrait s'être formée.

La formation de la fine couche semi-conductrice 112 peut être également suivie d'un autre nettoyage préalablement à la formation d'une couche métallique 116. Un tel nettoyage peut permettre d'empêcher, lors d'étapes ultérieures du procédé, d'inhiber une réaction entre un métal ou un matériau métallique et les matériaux semi-conducteurs respectifs des zones semi-conductrices 104, 108. Un tel nettoyage peut être réalisé par exemple à l'aide d'une solution acide aqueuse telle que du HF dilué ou peut être également réalisé ou complété par un nettoyage à l'aide d'un plasma, par exemple à base d'Ar ou d'un plasma détourné, par exemple à base d'ammoniac et de fluor.

Ensuite, on forme une couche métallique 116 sur la fine couche semi-conductrice 112. Cette couche métallique 116 peut être à base d'un métal tel que par exemple du Ni ou du Pt ou du Pd ou du Ti ou du Co ou d'un alliage des éléments précités, peuvent être envisagés (figure 1C).

L'épaisseur maximale de la fine couche semi-conductrice 112 peut être prévue en fonction de celle de la couche métallique 116 avec laquelle elle est destinée à réagir. La fine couche semi-conductrice 112 est destinée à être consommée totalement ultérieurement. L'épaisseur maximale de la fine couche semi-conductrice 112 peut être ainsi prévue en utilisant un rapport de volumes atomiques de l'élément considéré dans sa matrice.

Dans le cas d'une fine couche semi-conductrice 112 à base de Ge que l'on destine à réagir avec une couche de Ni, l'épaisseur E_{Ge} de la couche de Ge est prévue de sorte que : E_{Ge} < 1,6E_{Ni} avec E_{Ni} l'épaisseur de la couche de Ni.

La couche métallique 116 peut être déposée de manière à recouvrir entièrement la face du support 100 sur laquelle la fine couche semi-conductrice 112 a été réalisée. Le dépôt de matériau métallique peut être effectué par évaporation sous faisceau d'électron, ou dépôt chimique en phase vapeur (CVD pour « chemical vapour deposition »), ou dépôt électrochimique, ou préférentiellement par dépôt physique en phase vapeur (PVD pour « physical vapour deposition »), un dépôt PVD permettant un contrôle précis de l'épaisseur de la couche métallique 116 et des conditions garantissant une haute pureté du matériau la couche métallique 116.

L'épaisseur de la couche 116 de métal ou d'alliage métallique réalisée peut être comprise par exemple entre 1 nm et 50 nm.

Ensuite, on forme des zones d'alliage de métal et de semi-conducteur sur les zones semi-conductrices 104 et 108.

Pour cela, un premier traitement thermique, encore appelé recuit, peut être ensuite réalisé.

Ce recuit peut être réalisé sous vide ou sous atmosphère contrôlée. Ce recuit est également réalisé selon une température et une durée données, en fonction des épaisseurs respectives de la fine couche semi-conductrice 112, des zones semi-conductrices 104 et 108, et de leurs matériaux semi-conducteurs respectifs. Par exemple, lorsque les zones semi-conductrices 104 et 108 ont une épaisseur entre 20 nm et 50 nm, que la fine couche semi-conductrice 112 a une épaisseur par exemple de l'ordre de 5 nm, et que la couche métallique 116 a une épaisseur comprise entre 10 nm et 15 nm, ce premier recuit peut être effectué à 220°C et selon une durée comprise, par exemple, entre 30s et 90s.

La formation d'un composé de métal et de semi-conducteur par réaction à l'état solide passe par plusieurs étapes : une phase de germination, une phase de croissance latérale ou coalescence et une phase de croissance en épaisseur.

L'épaisseur et le matériau semi-conducteur de la fine couche semi-conductrice 112 sont choisis de sorte qu'elle présente une barrière de germination plus faible que celle d'au moins une des zones semi-conductrices parmi la zone 104 et la zone 108.

Par barrière de germination ou barrière à la germination, on entend une énergie nécessaire pour permettre de mettre en oeuvre une germination, encore appelée nucléation, à partir d'une zone semi-conductrice.

Selon une possibilité, la fine couche semi-conductrice 112 peut être choisie à base de l'un des matériaux semi-conducteurs parmi le premier matériau semi-conducteur et le deuxième matériau semi-conducteur ayant, à conditions thermodynamiques égales et à dimensions égales, la barrière de germination la plus faible.

Une étape de germination sur une zone semi-conductrice nécessite une énergie communément appelée énergie libre de Gibbs, qui dépend à la fois d'un terme a.σr² lié à sa surface (avec a est un terme géométrique, σ l'énergie de surface de la nouvelle phase et r le rayon du germe) et d'un terme b.ΔGᵥ.r³ lié à son volume (avec b est un terme géométrique, ΔGᵥ l'énergie de volume de la nouvelle phase et r le rayon du germe). Les facteurs σ et .ΔGᵥ dépendent des matériaux en présence.

La phase de germination qui dépend de la barrière de nucléation des matériaux en présence est très consommatrice en énergie. A surfaces égales et volumes égaux, la barrière de germination est plus faible pour le germanium que pour le silicium et pour le SiGe que pour le Si.

Dans le cas où la zone 104 et la zone 108 sont respectivement à base de Silicium et de Germanium, la fine couche 112 est ainsi à base d'un matériau semi-conducteur choisi de manière à avoir une barrière de germination plus faible que celle de la zone 104 de silicium.

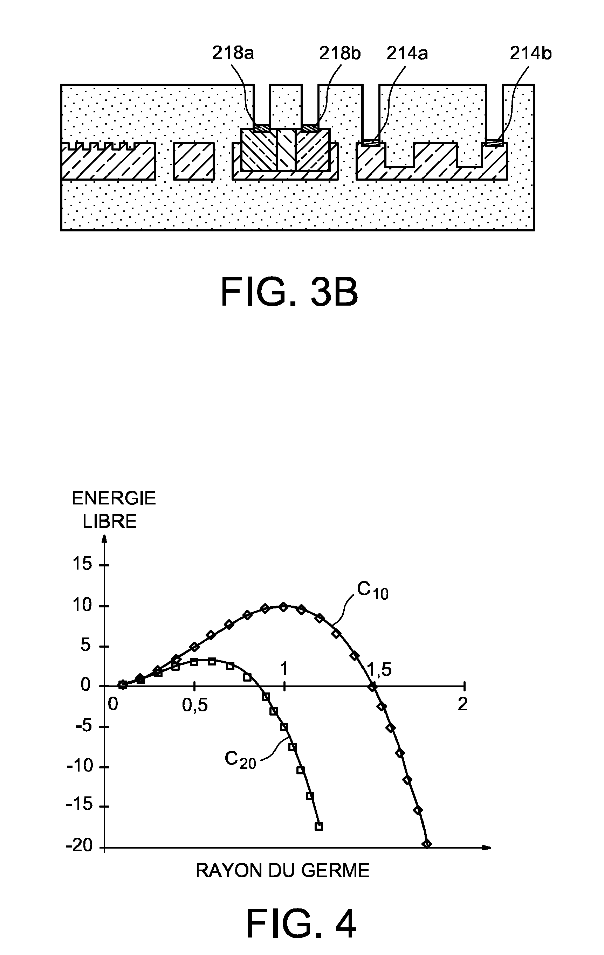

Dans le cas où la zone 104 et la zone 108 sont respectivement à base de Silicium et de Germanium, la fine couche 112 peut être ainsi choisie à base de Ge, une zone de Ge ayant une barrière de germination plus faible qu'une zone de Si de même dimensions, comme cela est illustré par exemple sur la figure 4 donnant par exemple des courbes C₁₀ et C₂₀ de variation de l'énergie de germination d'une zone de Si (courbe C₁₀) et d'une zone de Ge (courbe C₂₀) en fonction du rayon d'une nouvelle phase.

Cette première étape de recuit peut être réalisée de manière à former une couche 130 d'alliage de métal et de semi-conducteur comportant des régions de composés métal semi-conducteur riche en métal sur les zones semi-conductrices 104, 108.

Cette couche 130 comprend au moins une première région 134 à base d'au moins un alliage métal-semi-conducteur M₁₋ₓ(Si_{1-y}Ge_{y})x, avec M qui peut être du Ni, riche en métal.

La couche 130 d'alliage de métal et de semi-conducteur comprend au moins une deuxième région 138 à base d'un autre alliage métal-semi-conducteur M₁₋ₓ(Ge)x, riche en métal avec M qui peut être du Ni (figure 1D).

La présence de la fine couche semi-conductrice 112 à base de Ge permet de réduire le budget thermique de réalisation simultanée de zones d'alliage de semi-conducteur et de métal. Lorsque les zones 104 et 108 sont respectivement à base de Si et de Ge, et que la couche métallique 116 est à base de Ni, le recuit peut être réalisé par exemple à une température comprise par exemple entre 150°C et 250°C. Ensuite, selon une première alternative, un retrait sélectif du métal n'ayant pas réagit en surface des zones diélectriques et éventuellement en surface de la couche 130 d'alliage de matériau métallique et de semi-conducteur peut être alors réalisé. Ce retrait sélectif peut être réalisé à l'aide d'une solution chimique permettant de graver sélectivement la couche métallique vis-à-vis du siliciure. Lorsque la couche métallique est à base de Ni, un retrait à l'aide d'une solution chimique communément appelée Caro (H_{z}O₂; H₂SO₄; H₂O) à chaud entre 30°C et 70°C ou à base de (HF ; HCl) peuvent être mis en oeuvre.

Selon une autre alternative, un deuxième traitement thermique sous vide ou sous atmosphère contrôlée, peut être effectué. Un tel traitement permet de modifier la composition des régions 134, 138 de composés ou d'alliages de matériau métallique et de semi-conducteur formés respectivement sur les zones semi-conductrices 104, 108. Un tel traitement thermique peut permettre de mettre en oeuvre des régions 134, 138 à base d'un composé de matériau métallique et de semi-conducteur présentant des résistances réduites.

Pour le procédé qui vient d'être décrit, l'épaisseur de métal de la couche 116, ainsi que le ou les traitement(s) thermique(s) réalisé(s), en particulier le ou les couple(s) temps-température du ou des recuits réalisé(s), sont ajustés de telle manière que la totalité de la fine couche 112 semi-conductrice déposée est consommée.

Ainsi, dans le cas où la fine couche semi-conductrice 112 a été réalisée à base de Ge, en consommant totalement cette fine couche 112 on évite de conserver une interface Ge/Si sur la zone semi-conductrice 104 qui confèrerait à cette zone une résistance d'accès élevée.

Lorsque la couche métallique 116 et la fine couche semi-conductrice 112 sont réalisées respectivement à base de Ni et à base de Ge, et que la première zone semi-conductrice 104 et la deuxième zone semi-conductrice 108 sont respectivement à base de Si et de Ge, lors du ou des recuit(s) thermique(s), une zone de NiGe a tendance à se former sur la zone 108 à base de germanium et une zone de Ni₁₋ₓ(Si_{1-y}Ge_{y})ₓ a tendance à se former sur la zone 104 à base de silicium.

Selon une possibilité de mise en oeuvre, le recuit de formation peut être réalisé sous vide ou sous atmosphère inerte à base de N₂, Ar, He, en particulier lorsque les températures de recuit sont inférieures à 400 °C.

Pour empêcher une éventuelle formation de cavités au dessus des zones semi-conductrices 104, 108 entre ces dernières et les zones de composé ou d'alliage métal-semi-conducteur réalisés, le premier recuit et/ou le ou les recuits thermiques réalisés après dépôt de la couche métallique 116 peuvent être réalisés dans une atmosphère oxydante par exemple tel que cela est décrit dans le brevet US 2011/0143534.

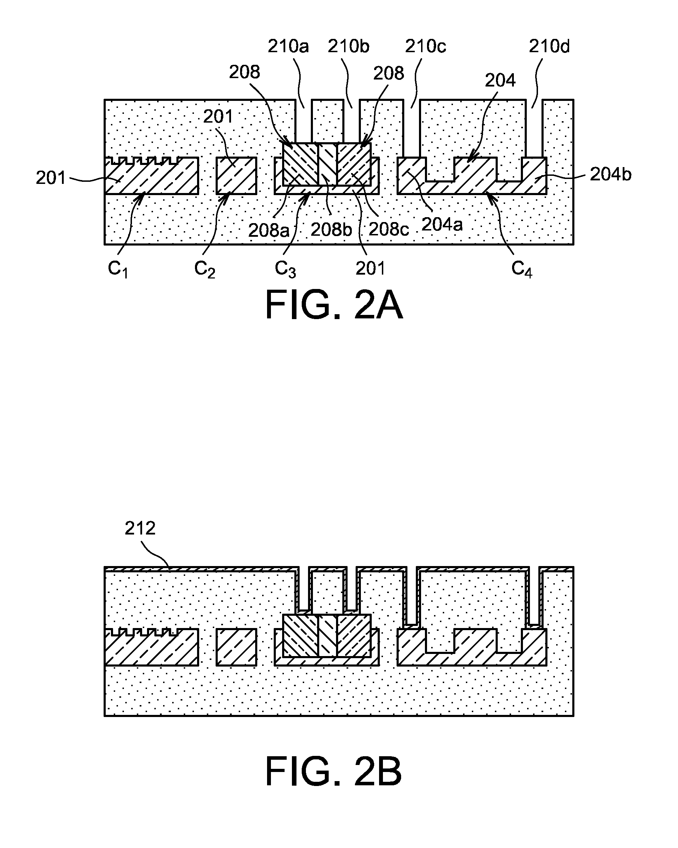

Un autre exemple de procédé va être donné en liaison avec les figures 2A-2E.

Dans cet exemple, le procédé est effectué sur une structure hétérogène comportant plusieurs zones semi-conductrices à base de matériaux différents. Cette structure hétérogène peut être un dispositif opto-électronique, dont un ou plusieurs composants sont en cours de réalisation.

Ce dispositif comprend un ou plusieurs composants optiques tels que par exemple un coupleur C₁ de fibre optique, et un guide d'onde C₂ et/ou un ou plusieurs composants opto-électroniques tels que par exemple un photo-détecteur C₃, et un modulateur optique C₄. Le coupleur C₁, le guide d'onde C₂, le photo-détecteur C₃, et le modulateur optique C₄, peuvent avoir été réalisés à partir de zones ou d'une couche à base d'un premier matériau semi-conducteur 201, par exemple du silicium.

Le photo-détecteur C₃ peut être formé d'un bloc semi-conducteur 208 ou d'une zone semi-conductrice 208 à base d'un autre matériau semi-conducteur, par exemple du Germanium, reposant sur le premier matériau semi-conducteur 201. La zone 208 du photo-détecteur peut comprendre une région 208a semi-conductrice dopée N, une région 208b de matériau semi-conducteur intrinsèque, ainsi qu'une autre région 208c semi-conductrice dopée P.

Le modulateur optique C₄ peut être formé d'une zone 204 à base du premier matériau semi-conducteur 201 et comprendre une région 204a dopée N, ainsi qu'une région 208c dopée P (figure 2A).

Les composants C₁, C₂, C₃, C₄, peuvent être recouverts d'un masquage 209, par exemple formé d'un matériau isolant tel que du SiO₂, et comportant des ouvertures 210a, 210b, dévoilant respectivement la région 208a dopée N de la zone 208 du photo-détecteur, et la région 208c dopée P du photo-détecteur, ainsi que des ouvertures 210c, 210d, dévoilant respectivement la région 204a dopée N du modulateur, et la région 204b dopée P du modulateur.

On forme ensuite (figure 2B) une fine couche semi-conductrice 212 à base d'un matériau semi-conducteur choisi de manière à avoir une barrière de nucléation inférieure à celle du matériau semi-conducteur parmi les matériaux semi-conducteurs formant respectivement le modulateur C₄ et le photo-détecteur C₃ ayant la barrière de nucléation la plus élevée.

Par exemple, dans le cas où matériau semi-conducteur formant le modulateur C₄ est du Si et que le matériau semi-conducteur formant le photo-détecteur C₃ est du Ge, la fine couche semi-conductrice 212 peut être, par exemple, à base de Ge. La fine couche semi-conductrice 212 peut être réalisée par dépôt conforme et de manière à recouvrir au fond des ouvertures 210d, 210c, 210b, 210a, les régions 204b, 204a, 208c, 208a. La fine couche semi-conductrice 212 peut avoir une épaisseur comprise par exemple entre 2 nm et 10 nm.

Préalablement au dépôt de la fine couche 212, un nettoyage des régions 204b, 204a, 208c, 208a peut avoir été réalisé.

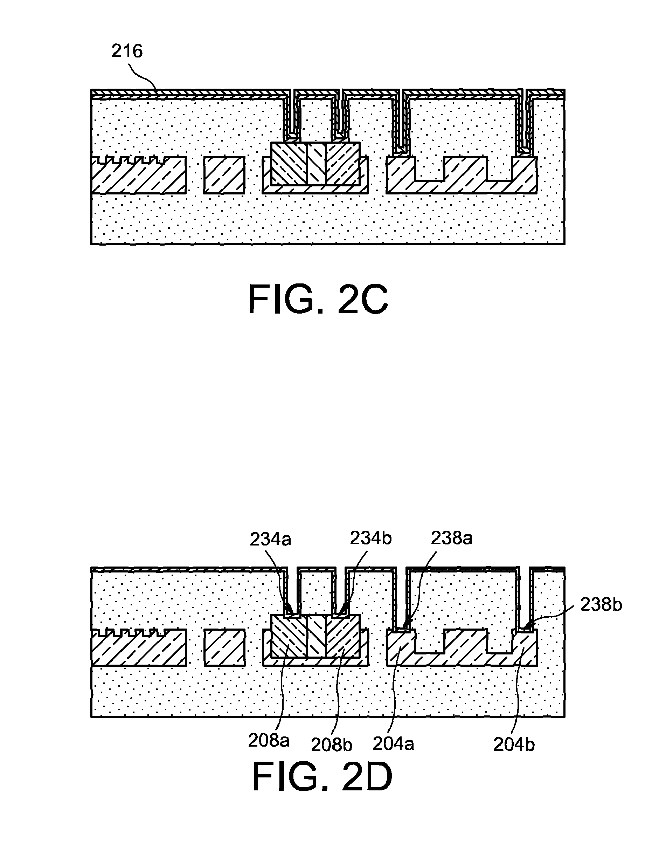

Après, avoir formé la fine couche semi-conductrice 212, on dépose une couche de matériau métallique 216, par exemple à base de Ni, de manière conforme et afin de recouvrir la fine couche semi-conductrice 212. Le dépôt de la couche métallique 216 peut être réalisé de manière à ne pas remplir complètement les ouvertures 210d, 210c, 210b, 210a (figure 2C).

Puis, on effectue un traitement thermique ou un recuit afin de réaliser un composé à base de métal et de semi-conducteur. Le recuit peut être effectué par exemple à une température comprise par exemple entre 250°C et 350°C pendant une durée par exemple comprise entre 20s et 120s.

Ce recuit est réalisé de manière à consommer entièrement le matériau semi-conducteur de la fine couche semi-conductrice 212, et réaliser une consommation partielle du matériau semi-conducteur des régions 208a, 208c, 204a, 204b. Des zones 234a, 234b, 238a, 238b, à base d'un composé formé de matériau semi-conducteur et de métal sont ainsi réalisées dans les ouvertures 210a, 210b, 210c, 210d (figure 2D).

Un autre recuit peut être ensuite réalisé. Cet autre recuit peut être un recuit de stabilisation ou un recuit destiné à ce que la réaction entre le matériau métallique et les matériaux semi-conducteurs s'achève.

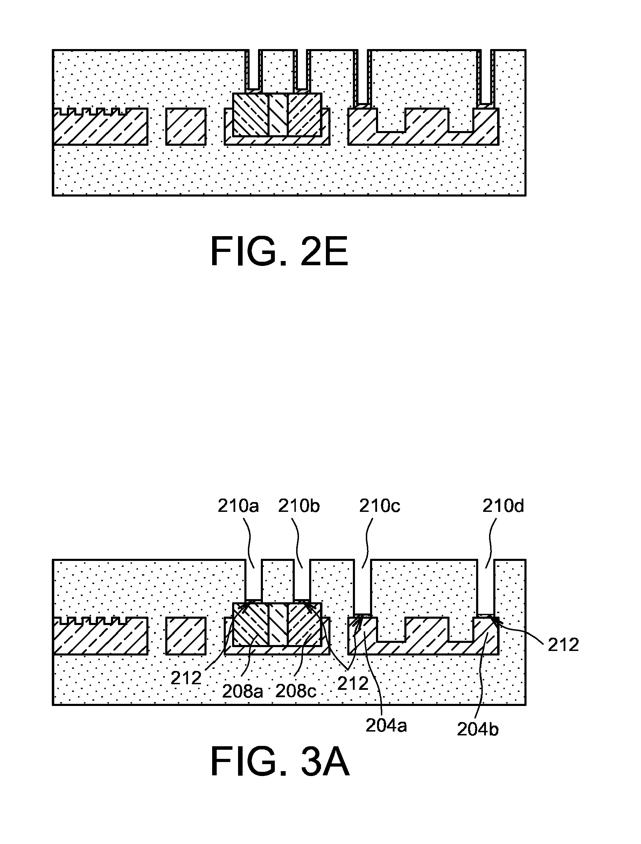

Ensuite on peut effectuer un retrait de la couche reposant sur le masquage formé par réaction lors du recuit entre la fine couche semi-conductrice 212 et la couche de matériau métallique 216 (figure 2E).

Selon une variante du procédé qui vient d'être décrit, la fine couche semi-conductrice 212 peut être réalisée par formation sélective sur les régions 208a, 208c, 204a, 204b, dévoilées respectivement par les ouvertures 210a, 210b, 210c, 210d, et de manière à ne recouvrir que ces régions (figure 3A).

Ensuite, on effectue les étapes de dépôt de la couche métallique de manière à recouvrir la fine couche semi-conductrice 212 au fond des ouvertures 210a, 210b, 210c, 210d.

Puis, on réalise un traitement thermique de manière à former des zones 218a, 218b, à base d'un composé formé d'un matériau métallique et de Ge, et des zones 214a, 214b, à base d'un composé formé d'un matériau métallique, de Si et de Ge (figure 3B).

## Revendications

1. Procédé de réalisation d'un dispositif à semi-conducteur comportant une pluralité de zones à base d'un composé de matériau métallique et de matériau semi-conducteur, comprenant les étapes de :
- formation sur un support (100, 200) comportant au moins une première zone semi-conductrice (104, 204) à base d'un premier matériau semi-conducteur et d'au moins une deuxième zone semi-conductrice (108, 208) à base d'un deuxième matériau semi-conducteur différent du premier matériau semi-conducteur, d'une fine couche semi-conductrice (112, 212) en contact avec le premier matériau semi-conducteur et le deuxième matériau semi-conducteur, la fine couche semi-conductrice ayant une épaisseur et étant à base d'un matériau semi-conducteur donné choisis de sorte que la fine couche semi-conductrice présente une barrière à la germination inférieure à celle d'au moins une desdites première zone semi-conductrice et deuxième zone semi-conductrice,
- dépôt d'une couche métallique (116) sur la fine couche semi-conductrice (112, 212),
- recuit selon une durée donnée et une température donnée de manière à former au moins une première région (134) à base d'un premier composé de matériau métallique et de matériau semi-conducteur sur ladite première zone semi-conductrice (104, 204) et au moins un deuxième région (138) à base d'un composé de matériau métallique et de matériau semi-conducteur sur ladite deuxième zone semi-conductrice (108, 208).

2. Procédé selon la revendication 1, dans lequel ledit premier matériau semi-conducteur est du Si.

3. Procédé selon la revendication 1 ou 2, dans lequel ledit deuxième matériau semi-conducteur est du Ge. ou du SiGe

4. Procédé selon l'une des revendications 1 à 3, dans lequel ledit matériau semi-conducteur donné de la fine couche semi-conductrice (112) est ledit deuxième matériau semi-conducteur.

5. Procédé selon l'une des revendications 1 à 4, comprenant en outre, après ladite étape de recuit, le retrait d'une portion restante de ladite couche métallique.

6. Procédé selon la revendication 5, comprenant en outre : après ledit retrait d'une portion restante de ladite couche métallique, au moins un autre recuit.

7. Procédé selon l'une des revendications 1 à 6, dans lequel la durée donnée et la température donnée dudit recuit et l'épaisseur de la couche métallique sont prévus de sorte que lors dudit recuit, le matériau semi-conducteur donné de ladite fine couche semi-conductrice est totalement consommé.

8. Procédé selon l'une des revendications 1 à 7, ladite couche métallique étant à base de Ni.

9. Procédé selon l'une des revendications 1 à 8, le recuit étant réalisé sous atmosphère oxydante.
